# EUROPEAN PATENT SPECIFICATION

(11) **EP 0 779 859 B1**
(45) Date of publication and mention of the grant of the patent: **09.07.2003**
(21) Application number: 95931518.5
(22) Date of filing: 11.08.1995
(51) Int. Cl.: B32B 5/16, B24D 3/00, B24D 3/02, C09C 1/68, C09K 3/14, C30B 23/00, C30B 25/00, C30B 28/12, C30B 29/04, C30B 31/00, H01L 29/04

(54) **ORIENTED CRYSTAL ASSEMBLIES**
ORIENTIERTE KRISTALLANORDNUNG
ENSEMBLES DE CRISTAUX ORIENTES

(30) Priority: 31.08.1994 US 299240; 12.10.1994 US 322681
(43) Date of publication of application: 25.06.1997
(73) Proprietor: Roberts, Ellis E., Los Osos, CA 93412 (US)
(72) Inventor: Roberts, Ellis E., Los Osos, CA 93412 (US)
(74) Representative: Mitscherlich, Hans, Dipl.-Ing.
(86) International application number: US9510195
(87) International publication number: WO96006732

(56) References cited:
- EP-A- 0 573 943
- EP-A- 0 589 464
- WO-A-92/01827
- WO-A-92/22689
- US-A- 3 895 313
- US-A- 4 925 457
- US-A- 5 082 359
- US-A- 5 107 626
- US-A- 5 152 917
- US-A- 5 264 070
- US-A- 5 296 207
- US-A- 5 304 223
- US-A- 5 371 383
- GEIS: "Device quality diamond substrates" DIAMOND AND RELATED MATERIALS., vol. 1, no. 5/6, 15 April 1992, pages 684-687, XP000356302 AMSTERDAM NL
- APPL. PHYS. LETT., Volume 58, Number 22, issued 03 June 1991, GEIS et al., "Large-Area Mosaic Diamond Films Approaching Single-Crystal Quality", pages 2485-2487.

## Description

### Technical Field

This invention relates to oriented crystal assemblies and more particularly to an article of oriented single synthetic crystals and to a method for making such an article.

Diamond has numerous physical properties that are well known and which have great utility for industrial purposes but which in the past have not been fully exploited. These properties include abrasion and wear-resistance, thermal conductivity, electrical insulation, and receptivity to the deposit of a layer of diamonds by chemical vapor deposition.

The very high degree of abrasion resistance exhibited by diamond varies with the crystallographic direction of hardness by a factor of as much as about one hundred times, and this most resistant direction is along the diagonal of a cubic face in the plane of the face. Diamond crystals also have another direction of high hardness along a line tangential to an edge of the crystal; crystals of cubic boron nitride (CBN) have a similar direction of high hardness.

Until the present invention, however, it has not been recognized how to take advantage of such crystallographic directions of hardness of diamond, CBN, and perhaps other materials, when these materials are employed to make an article having wear-resistant or abrasive qualities and other desired characteristics. Thus, the prior art devices have not optimized the hardness characteristics of a hard surface including particles of diamond and CBN.

### Background Art

In abrasives, for example, the grits or particles of the prior art have been incorporated in a backing member in either a random manner or an oriented manner. The prior art orientation has been to disperse the grits uniformly (U.S. Patent No. 4,925,457), to arrange planar faces of the grits so they seat flat against a workpiece (U.S. Patent No. 3,230,672), or to orient the grit particles by electrostatic or electromagnetic means (U.S. Patent Nos. 4,240,807 and 5,203,881).

Although these orientations may provide useful abrasive articles, these and like prior art abrasive or wear-resistant articles have failed to take advantage of the maximum hardness available in the abrasive materials used, such as diamond and CBN. The concept of orienting particles in a backing member so as to transfer to the abrasive or wear-resistant surface as a whole the hardness qualities of the individual particles per se has not been recognized. Thus, it has not been known how to control the hardness of the surface either to insure that the resulting surface would have the maximum hardness possible or to provide a predetermined degree of hardness for abrasive or bearing applications.

For semiconductor applications, the Geis et al. PCT application and related article (WO 92/01827 published 6 February 1992, and Geis et al. "Large-Area Mosaic Films Approaching Single-Crystal Quality," *Applied Physical Letters,* Vol 58, No. 22 (3 June 1991), 2485-2487) recognize that diamond's excellent electrical properties have not been fully utilized. These references teach the placing of synthetic diamond seed crystals of 0.10 mm diameter or less in spaced complementary pits or grooves, and subsequently growing a film about the seeds by chemical vapor deposition. Geis et al. intentionally separate the seed crystals to enable the CVD crystal growth to envelope the seeds. Thus, although Geis et al. state that such placement orients the crystallographic directions, their method creates spaces or gaps between adjacent seed crystals. They state that at the point where adjacent crystals merge, there is the possibility that crystal defects may occur. Moreover, Geis et al. is concerned with electrical applications and thus does not teach how to produce an abrasive or bearing surface having a crystallographic direction of maximum abrasive resistance.

### Disclosure of the Invention

The present invention involves an abrasive article (36, 236, 336) comprising a backing member (38, 238, 338) having amounting surface (40, 240, 340) a group of synthetic single crystals (50, 350) secured to the backing member in spaced relationship and distributed over said mounting surface, each of said crystals being a polyhedron with side faces meeting in edges of the crystal, each crystal also having predetermined directions of hardness (90, 92, 248, 249) along lines in the plane of each face and tangential to each edge, the article being characterized in that:
the faces and edges constitute abrading portions of the crystals, and
the crystals are oriented on the backing member with a selected abrading portion of each crystal projecting outwardly from the mounting surface (40, 240, 340) with all the corresponding lines of hardness being either in alignment or parallelism so that the group of crystals exhibits a common direction of hardness.
In an embodiment of the invention the abrasive article comprises article synthetic single crystals of uniform size and shape selected from the group consisting of diamond or cubic boron nitride and held in a formation with selected crystallographic directions of the crystals oriented in the same direction. The present invention also involves a method for producing such abrasive articles from a plurality of synthetic single crystals of the same polyhedral shape and of the same size wherein each of said crystals has at least one portion having a crystallographic direction of hardness which is the same in all of the crystals, characterised by said at least one portion being a workpiece-engaging portion, and the steps of:
orienting the crystals to position and align said workpiece-engaging portions of each article so that all of said predetermined crystallographic directions of hardness are aligned and whereby said workpiece-engaging portions collectively exhibit a common crystallographic direckion of hardness; and
securing the crystals together as positioned and aligned in said orienting step so that said workpiece-engagingportions are positioned to collectively engage a workpiece.
The article is useful as an abrasive, a bearing, a heat sink or a semiconductor.

It is an object of the present invention to maximize the characteristics of a surface composed of hard materials such as diamond, CBN, and perhaps other materials, to produce an article having various industrial uses, such as abrasives, bearings, heat sinks and semiconductors.

It is a further object of this invention to take advantage of the fact that synthetic single crystals of diamond and CBN have predetermined crystallographic directions lying along lines in contact with certain portions of their crystals, by aligning these directions when the crystals are positioned in a working formation.

It is also an object to take advantage of the fact that diamond and CBN are commercially synthesized in shapes and sizes that permit single crystals of these materials to be oriented with their crystallographic directions aligned.

A further object is to provide an article including a formation of synthetic single crystals for abrading a workpiece which, as contrasted with prior art tools: abrades faster; lasts longer; requires less frequent replacement and adjustment; is less costly to operate; maintains tolerances longer; saves abrasive material; requires less power; and minimizes dulling or flatting of grains.

Another object is to provide a method for making the article of the present invention.

### Brief Description Of The Drawings

Fig. 1 is a plan view of one embodiment of an abrasive article made in accordance with the present invention but showing the article on a greatly enlarged scale from actual size.
Fig. 2 is a cross-sectional view taken along line 2-2 of Fig. 1.
Fig. 3 is an isometric view of a single, synthetic, cubic crystal of diamond as used in the article of Fig. I but greatly enlarged from Fig. 1.
Fig. 4 is an isometric view of a single, synthetic, predominately cubic crystal of diamond, but with small octahedral facets, as used in the present invention and also greatly enlarged from actual size.
Fig. 5 is an enlarged view of a face of the cubic crystal of Fig. 3 showing directional lines of hardness and the Miller indices of the cube face and hardness directions.
Fig. 6 illustrates a step of the method of the present invention and specifically is an isometric view of a corner of a template containing three cubic crystals oriented by the template into desired positions.
Fig. 7 illustrates a portion of an alternate form of template used in practicing the method referred to in regard to Fig. 6.
Fig. 8 illustrates another step of the method of the present invention and specifically is a cross section of the template and crystals therein, as if taken along line 8-8 of Fig. 6 when the template is full of crystals, and further showing a backing member of epoxy overlaying the crystals and the template.
Fig. 9 is a cross-section taken along the same plane as Fig. 8 but showing the backing member and the crystals, that is the abrasive article, removed from the template.
Fig. 10 is a plan view of another embodiment of an abrasive article made in accordance with the present invention and also shown on a greatly enlarged scale from actual size.
Fig. 11 is a cross-sectional view taken along line 11-11 of Fig. 10.
Fig. 12 is an edge view of the cubic diamond crystal of Fig. 3, although on a reduced scale from Fig. 3, showing its orientation as used in the article of Fig. 10, but enlarged from Fig. 10, and further showing its second hardest directional line of hardness and Miller index.
Fig. 13 is a face view of the diamond crystal of Fig. 12.
Fig. 14 illustrates a step of an embodiment of the present method used to make the article shown in Fig. 10 and specifically is an isometric view of a corner of a template containing two cubic crystals oriented by the template into desired positions which differ from the positions of Fig. 6.
Fig. 15 illustrates a step similar to that illustrated by Fig. 8 but pertains to the method of making the article shown in Fig. 10 and specifically is a cross-section of the template and crystals therein, as if taken along line 15-15 of Fig. 14 when the template is full of crystals, and further showing a backing member of epoxy overlaying the crystals and the template.
Fig. 16 is a cross-section along the same plane as Fig. 15 but showing the article of Fig. 10 removed from the template.
Fig. 17 is a plan view of a portion of a variation of the second embodiment of an abrasive article made in accordance with the present invention.
Fig. 18 is an isometric view of part of a template for use in making the variation shown in Fig. 17.
Fig. 19 is a plan view of a third embodiment of an abrasive article made in accordance with the present invention using tetrahedral cubic boron nitride crystals and also shown on a greatly enlarged scale from actual size.
Figs. 20 and 21 are partial cross-sectional views taken along lines 20-20 and 21-21, respectively, of Fig. 19.
Fig. 22 is a greatly enlarged isometric view of a tetrahedral crystal of cubic boron nitride as used in the article of Fig. 19 but greatly enlarged from Fig. 19 and showing Miller notations for two of the faces of the crystal.
Fig. 23 is a face view of the crystal of Fig. 22 on a reduced scale and also showing a Miller notation.
Fig. 24 is an edge view of the crystal of Fig. 23 but turned ninety degrees therefrom and again showing a Miller notation.
Fig. 25 is a fragmentary isometric view similar to Fig. 18 but showing a template used to make the article of Fig. 19.
Figs. 26 and 27 are cross-sectional views similar to Figs. 15 and 16 but showing steps for making the article of Fig. 19 and taken along the same plane as Fig. 21.
Fig. 28 is an isometric view of a comer of a template used to make a variation, not shown, of the embodiment shown in Fig. 19.
Figs. 29 and 30 are schematic views showing how the articles of the present invention are used in a tool to surface a workpiece along a linear path but specifically showing the article of Fig. 19.
Figs. 31 and 32 are schematic views showing how the articles of the present invention are used in a tool to surface a workpiece along a rotary path but specifically showing articles made in accordance with the embodiment of Fig. 17.
Fig. 33 is a plan view, enlarged approximately two times actual size, of an assembly of synthetic cubic crystals of diamond, or like material, made in accordance with the present invention.
Fig. 34 is an elevation or edge view of the assembly of Fig. 33.
Fig. 35 is an isometric view of formation of synthetic cubic diamond crystals illustrating the aligned crystallographic directions of hardness by directional arrows and Miller indices. Again, the crystals and thus the assembly are enlarged from actual size. It is also noted that the crystals shown in Fig. 35 are in fact cubic, although they may not appear so because of the rules of isometeric projection.
Fig. 36 is an isometric view of a comer of the assembly of Fig. 35 showing a binder applied to the crystals and showing in dashed lines the edges of crystals under the binder.
Fig. 37 is also an isometric view of the initial steps of assembling cubic diamond crystals into an integrated formation by placing the crystals in side-by-side contact on the bottom flat surface and in the corner of a tray inclined toward the corner. The scale is reduced from Fig. 35 but is still much larger than actual size.
Figs. 38a-38d are enlarged schematic views which illustrate additional steps of the method of this invention.
Figs. 39a-39f are also enlarged schematic views which illustrate additional steps of the method of this invention.

### Detailed Description

### Article of Manufacture- First Embodiment

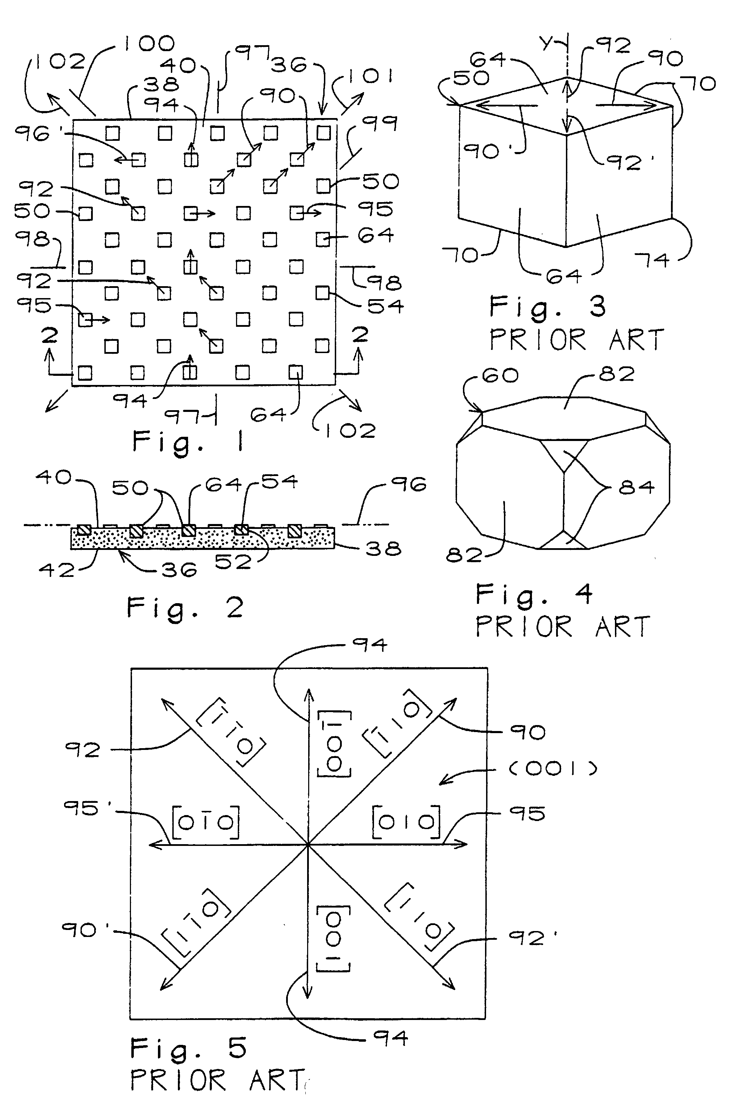

The first embodiment of the present invention is a wear-resistant or abrasive article 36 (Figs. 1 and 2) which includes a square backing member 38 of plastic or metal that has a mounting surface 40 and a back surface 42. A plurality of single synthetic cubic crystals 50 of diamond have first portions 52 individually embedded in a backing member formation and second portions 54 projecting outwardly from the mounting surface.

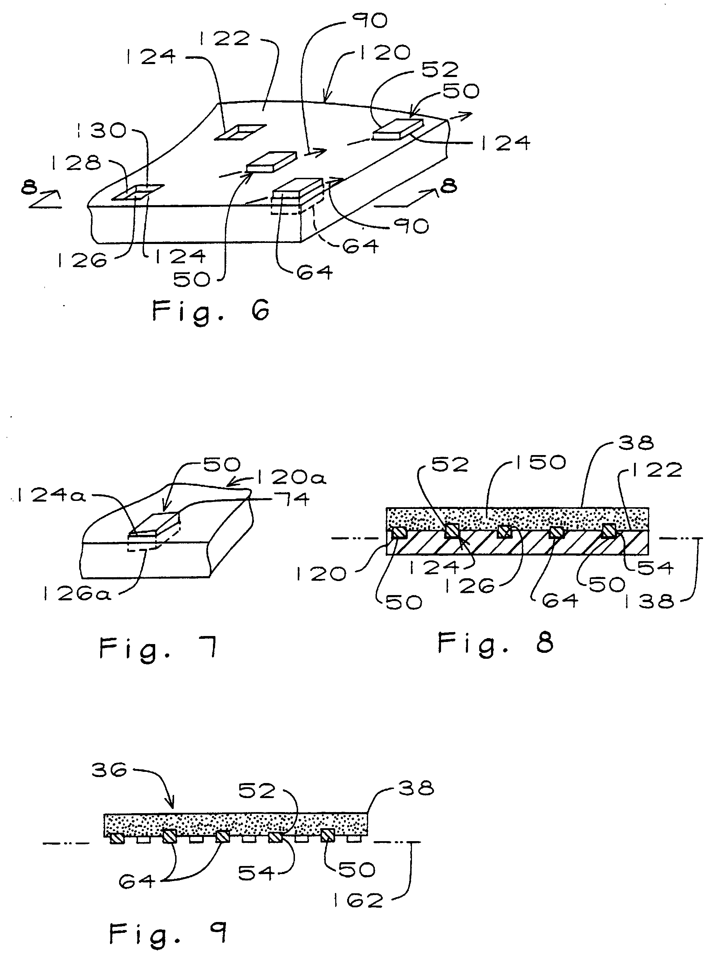

The use of single, synthetic diamond crystals, 50 in Fig.3 and 60 in Fig.4, is important to the present invention, and thus reference is now made to certain details about such crystals. In general, these crystals are regular polyhedrons but are produced in various specific shapes, namely, perfect cubes (Fig. 3); a range of cubo-octahedrons where the crystal faces vary from predominately cubic and minimally octahedron ( Fig. 4) to predominately octahedron and minimally cubic (not shown); and perfect octahedrons (not shown). It is preferred to use perfectly cubic crystals, as shown in Fig. 3, or predominately cubic crystals where the cubic faces predominate and the octahedral facets are minimal in size, as shown in Fig. 4. The principles of this invention, however, apply to other shapes of the cubic crystal system, to which diamond belongs, as will be understood in the subsequent description of the third embodiment of this invention using cubic boron nitride (CBN).

The cubic crystal 50 (Fig. 3) represents the described commercially available synthetic single diamond crystals which are up to 1 mm in size. The crystal 50 has six side faces 64, twelve edges 70, and eight corners 74. These faces are of course square and are referred to in the art and herein as cubic faces or as being in cubic planes.

The cubo-octahedral crystal 60 (Fig. 4) also represents commercially available synthetic single diamond crystals and has six faces 82, which are commonly referred to as cubic faces since that is their predominate shape, and eight smaller octahedral facets 84 at the corners. Crystal 21 is thus referred to as a predominately cubic crystal since the octahedral facets are relatively small as compared to the cubic faces.

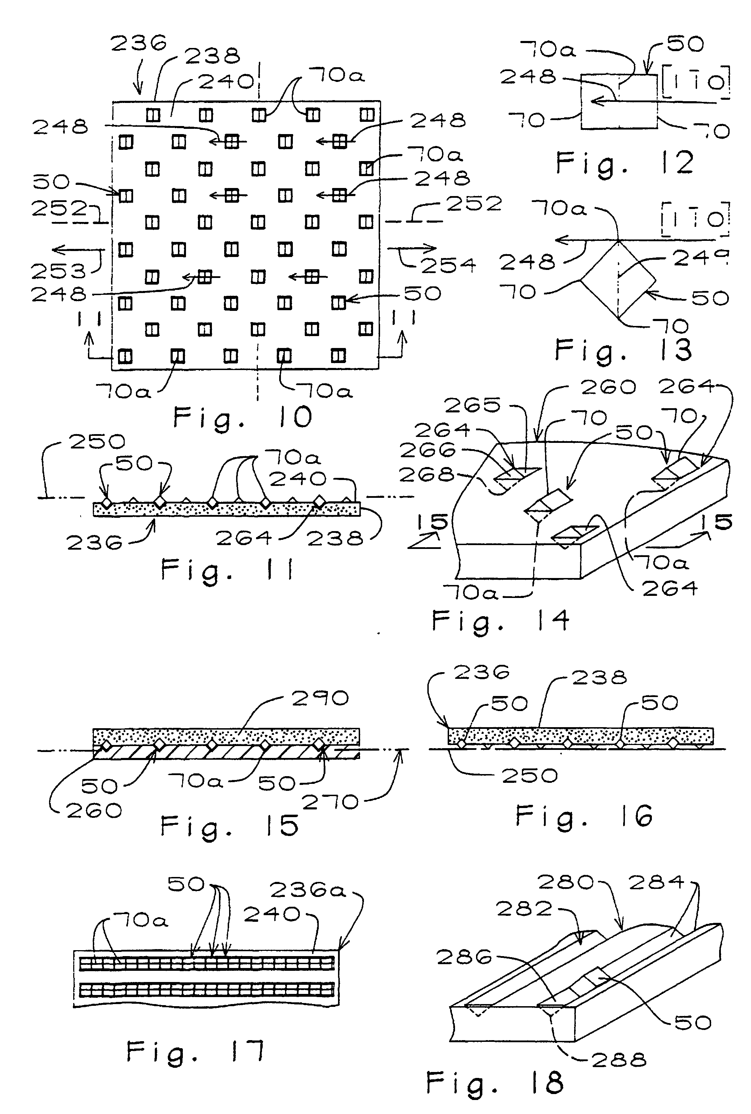

With reference to Fig. 5, a brief description is set forth of certain known crystallographic characteristics of a synthetic single diamond crystal, as 50 and 60, which are fully exploited in the present invention. Fig. 5 shows one of the faces 64 of the crystal 50. The crystal has crystallographic directions of maximum abrasive resistance or hardness in the plane of this cube face along the diagonal lines 90, 90' and 92, 92 ' of the face. It also has crystallographic directions of minimum abrasive resistance or hardness along lines 94, 94 ' and 95, 95' which are forty-five degrees from the diagonals or directions of maximum resistance. Therefore, the crystal exhibits degrees of directional hardness ranging from the diagonal maximum directional lines to the right-angular minimum directional lines. These lines of hardness may also be described as being tangential to their respective faces of the crystal. The appropriate Miller notations for the face and directional lines are denoted in Fig. 5. In view of the symmetry of the crystallographic structure of diamond crystals, each face of the crystal has the same crystallographic directions of hardness within the plane of its face.

Brief reference to certain nomenclature regarding the symmetry of crystals, as 50 or 60, (Figs. 3 and 4) will be useful in the subsequent description. As is known, the crystal has several planes of symmetry. One such plane is referred to in the art as a cubic plane which is an orthogonal plane which cuts through the crystal between and parallel to a pair of opposite faces, as 64. Another plane of symmetry is referred to in the art as a dodecahedral plane and is a diagonal plane that cuts through the crystal and contains a pair of opposite edges, as 70. The crystal also has several axes of symmetry one of which is represented, for example, by the letter y in Fig. 3 and passes through the center and opposite faces of the crystal and is perpendicular to such faces. Reference will be made to these planes and axes in the following description and claims.

Having described known characteristics of single synthetic cubic diamond crystals 50, 60, the present invention is primarily concerned with the orientation of these crystals in a predetermined manner in the article 36, one embodiment of which is shown in Figs. 1 and 2. It is to be noted that Fig. 1 is drawn four times actual size since the single synthetic cubic diamond crystals available are up to about 1 mm in size. It is also noted that for ease of illustration only perfectly cubic crystals are shown in Fig. 1 although in actual practice some of the crystals may be predominately cubic, as 60, and thus may have small octahedral facets 84.

In Figs. 1 and 2, each crystal 50 is individually mounted in the backing member 38, with its first or mounting portion 52 (Fig. 2), which is approximately half of the crystal, embedded in the backing member, and its second or abrading portion 54, which the other approximate half of the crystal, outside of the backing member. Another way of expressing the orientation of each crystal in the assembly is to state that each crystal is mounted in the formation with one of its cubic planes parallel to the mounting surface 40. The face 64 of each crystal at the extremity of the abrading portion 54 is referred to as an abrading face and is parallel to the mounting surface 40 and coplanar with the abrading faces of all the other crystals. These coplanar abrading faces thus define a working surface 96 for the article 36.

Incidentally, the amount of extension of the crystals 50 into or out of the backing member 38 is important to proper functioning of the article 36, but it is not a feature of the present invention. In the embodiment shown in Fig. 1, it is preferred that the mounting portions 52 of the crystals 50 are embedded in the backing member a distance of 0.6 mm, sufficient to hold the crystals securely in the backing member so as to prevent their dislodgment when force is applied to the crystals upon workpiece engagement, while providing sufficient workpiece engaging surfaces. Specific techniques for bonding abrasive particles, such as the crystals 50, 60, in a plastic or metal backing member are well-known but are subsequently briefly generally described herein as a part of the subject method.

The crystals 50 in the embodiment of Fig. 1 are preferably uniformly distributed about the backing member 38 in a checkerboard pattern and for this reason are arranged in orthogonal rows, indicated by lines 97, 98, and diagonal rows indicated by lines 99, 100, relative to the square backing member. The rows are in spaced relationship, and adjacent crystals in each row are spaced from each other. It is to be understood that the specific square shape of the backing member, the specific checkerboard pattern or row formation, the specific crystal spacing, and the density or concentration of crystals shown in Fig. 1 are not essential to the invention and may be varied depending on the application of the article 36.

Of prime significance to the invention, however, is the orientation of the crystals 50 relative to each other. With reference to Fig. 1, the crystals are individually fixed in the backing member 38 with their maximum directions of crystallographic hardness, as 90, 90', aligned along parallel diagonals of the formation which run in NE/SW directions, to use a compass analogy. Likewise, the directions 92, 92' are aligned along the NW/SE diagonals. It will of course be apparent that orientation of the crystals is not limited to such specific compass directions nor to the orientation of the article on the drawing sheet. With such an orientation, the lines of maximum hardness directions of the crystals in each diagonal row 99 are aligned along common lines, as 101, 102, and these common lines of all the diagonal rows are parallel with each other. Stated otherwise, corresponding lines of maximum hardness directions of individual crystals are either in alignment, or parallel, with corresponding lines of maximum hardness of all the other crystals. Also, these lines 90, 90' and 92, 92' of maximum hardness are tangential to their respective face extremities 64, lie in the working surface 96, and are parallel to the mounting surface 40 of the backing member 38.

It is to be observed that as used herein and in crystallographic terminology, the words "align" and "aligned" mean pointing in the same direction, but can also mean being coincident with a single line. Thus, the lines of maximum hardness 90 of the crystals 50 in Fig. 1 are "aligned" in the sense that they all point in a NE direction in Fig. 1, whereas those directional lines 90 of the crystals in a given diagonal row are "aligned" in that they are coincident along a common line.

Conversely, corresponding lines, as 94, of minimum hardness directions of all the crystals 50 (Fig. 1) in each of the NS orthogonal rows 98 are in alignment, as represented by common lines, as 104 and 106, and all of the corresponding minimum hardness lines in each such row are parallel with those in the other NS rows. The same is true for the EW rows. The lines of minimum hardness are thus also tangential to their respective face extremities 64, lie in the working surface 96, and are parallel to the mounting surface 40.

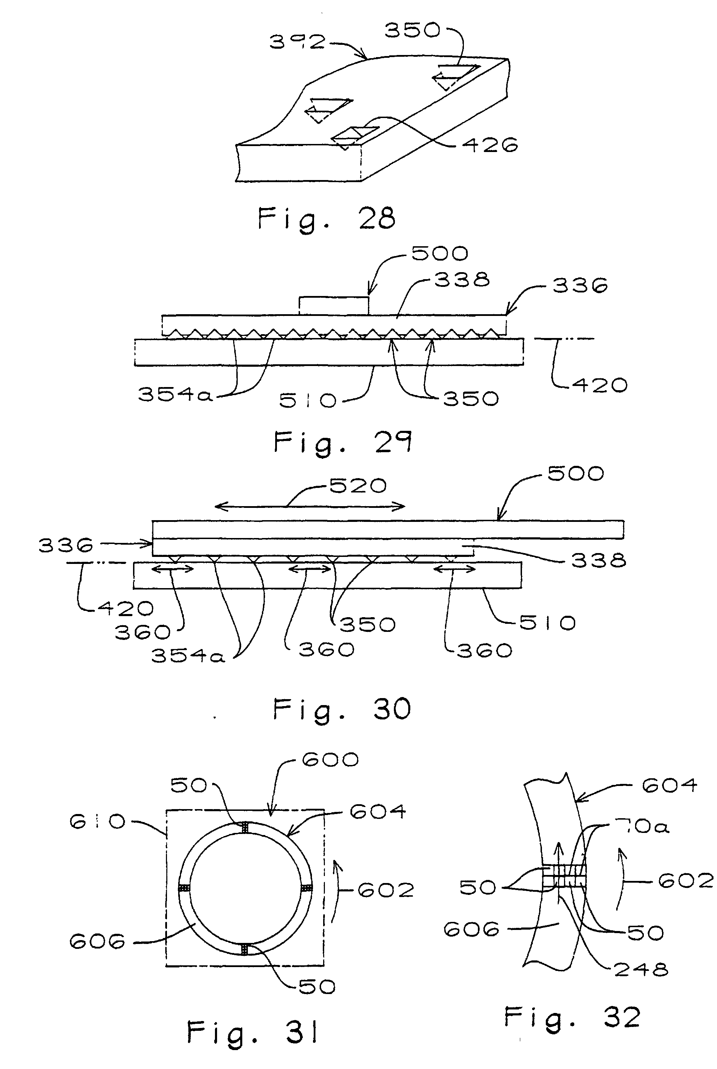

Therefore, it will be understood that the array, group, backing member, or formation of crystals 50 (Fig. 1) exhibits common directional lines, as 101 and 102, of maximum hardness which run diagonally of the backing member 38 and are parallel to the mounting surface 40. If the working surface 96 (Fig. 2) is moved across a workpiece (Figs. 29-32) in one of these diagonal directions, such as NE/SW, the crystals will exhibit their maximum hardness to the workpiece. Conversely, if the working surface is moved relative to a workpiece in the direction at forty-five degrees from common line 102, that is in a NS or EW direction, the surface will exhibit its minimum hardness to the workpiece. The working surface formed by the crystals thus exhibits common directions of maximum and minimum hardness and all the degrees of hardness in between, just like an individual crystal. With the present invention, then, the characteristics of an single crystal are imparted to the entire array of crystals.

With reference to Fig. 2, since the abrading portions 54 of the crystals 50 project outwardly of the backing member 38 equidistantly from the mounting surface 40 with their faces 64 defining the planar working surface 96, the crystals are able to contact a workpiece, not shown, simultaneously and thus apply force to the workpiece in an even manner. Wear on the crystals, and abrasion action on a workpiece, are therefore uniformly distributed.

### Method of Making the First Embodiment of the Article

The method for making the first embodiment of the article 36 (Fig. I ) of the present invention is described with reference to Figs. 6-9. The method employs a template 120, only a portion of which is shown in Fig. 6. The template has a top surface or plate 122 and a plurality of half-cubic shaped recesses, wells, or pockets 124 extending downwardly into the body of the template from the top surface and serving as receptors for the crystals 50. Each recess may be described as having the shape of a part of a cube cut along one of its cubic planes. Since only a portion of the template 120 is shown, only a few of the recesses are shown. It will be understood, however, that a complete template is slightly larger than the abrasive article 36 and has the same number and formation of recesses as there will be crystals in the article to be made. Thus, a complete template for making the article shown in Fig. 1 includes fifty recesses in ten rows of five each, running in both the length and the width of the template, with the recesses in adjacent rows offset from each other.

The recesses 124 (Fig.6) in the template 120 are of uniform shape and size. Each recess has a length and width (that is, the dimensions which lie in the plane of the surface 122) slightly greater than the edge dimensions of a cubic crystal 50, and a depth not quite as deep as such edge dimension. Thus, in this embodiment of the method, the recesses are slightly larger than 1 mm square and are 0.6 mm deep. Each recess has a bottom wall 126, and side and end walls 128 and 130 which are at right angles to the bottom wall. The recesses may be configured with slightly beveled inside corners, not shown, similar to the shape of the facets 84 of the predominately cubic crystals 60 (Fig. 4) that have minor octahedral facets.

Significantly, the recesses 124 (Fig. 6) are oriented in the template 120 in positions which will orient the crystals 50, 60 so that their corresponding crystallographic maximum hardness directions, as 90, are aligned. Thus, all of the side walls 128 are parallel with each other, and all of the end walls 130 are parallel with the other end walls. To achieve equidistant projection of the crystals from the backing member mounting surface 40, all of the bottom walls 126 are in a common plane 138 (Fig. 8).

Alternatively, a modified template 120a (Fig. 7) with modified recesses 124a may be used. Here, the bottom wall 126a of each recess 124a is angled upwardly a few degrees from the common plane 138. More specifically, the bottom wall 126a is angled diagonally upwardly from one bottom corner of the recess to the diagonally opposite comer. It will be understood that corresponding corners, for example, all the NE corners, are similarly tilted upwardly so as to make the angulation uniform throughout the template 120a.

The templates 120 or 120a (Figs. 6 and 7) are made of plastic, such as polyethylene or tetrafluoroethylene, or of metal, such as steel or aluminum, and are shaped by casting the plastic or metal against a master form, not shown, having cube-shaped protrusions. Alternatively, the template is made by stamping or pressing plastic or metal stock with an appropriately shaped master multiple projection die or a single cube-shaped die, again not shown since such metal-working techniques are well known in the art.

In carrying out the method of the present invention, a supply of synthetic single diamond crystals 50, 60 of cubic or predominately cubic shapes and of approximately the same size, currently 1 mm, is selected. It is important to size the crystals by precision screening, preferably using screens with square openings. Further shape control by automated single crystal weighing or settling in a fluid using Stokes Law may be used.

With the top surface 122 (Fig. 6) of the template 120 maintained in a generally horizontal plane, crystals 50, 60 are deposited on the top surface and spread thereover and thus lie in random orientation about the top surface. More crystals are deposited than there are recesses 124 so as to insure a quantity sufficient to fill all the recesses. The template is vibrated or tapped and, if necessary, slightly tilted to cause the crystals individually to gravitate into and be received by the recesses. Because of the complementary shapes of the recesses and the crystals and the slightly larger recess size relative the crystal size, crystals are individually accommodated into the recesses where they each stabilize, with one bottom face 64 of each crystal lying flat on the bottom wall 126 of its recess and with its side faces 64 in adjacent parallel relation to the side and end walls 128 and 130. The crystals project from the top surface 122 of the template a distance less than their edge dimension, preferably about 0.4 mm in the illustrated embodiment. If the template 120a using inclined bottom walls 126a is employed, as shown in Fig. 7, corresponding top corners 74 of the crystals 50 are tipped up relative to their diagonally opposite top corners along a diagonal, as 99 (Fig. 1), of the template. While all of the recesses are being filled or after they are filled, the template is inclined slightly and again vibrated or tapped in order to remove excess crystals from between the rows, so that the top surface 122 is clean of crystals while maintaining the crystals in the recesses into which they were received and in their oriented positions therein.

Each recess 124 or 124a (Figs. 6 and 7) is thus temporarily filled with a crystal 50 or 60, and the crystals are thus oriented with all of their corresponding crystallographic directions of maximum hardness 90, 90' and 92, 92 'aligned and the corresponding directions of minimum hardness, as 94, 94' and 96, 96', likewise aligned. The bottom faces 64 of the crystals lie flat against the bottom walls 126 of their recesses and thus coplanar with plane 138, and the first or mounting portions 52 of the crystals protrude outwardly from the template.

The subject method next involves steps for fixing the crystals 50, 60 in the described orientation and for removing them from the template, as 120 (Fig. 6). The template used has a non-adhesive top surface 122 and non-adhesive recess walls 126, 128 and 130, which can be accomplished by making the template of polyethylene or tetrafluoroethylene as previously suggested. A layer 150 (Fig. 8) of uncured plastic, such as an epoxy resin, is applied over the top surface 122, covering and completely immersing the mounting portions 52 of the crystals in the plastic. This layer is then cured and upon curing, this overlay of plastic becomes the backing member 38 fixing the crystals in their positions of crystallographic alignment with the faces 64 resting against the bottom walls 126 of the recesses 124 in their coplanar relationship. The backing member and the array of crystals are then removed as a unit from the template thereby yielding the article 36 (Fig. 9).

In its basic form, the article 36 (Figs. 1, 2 and 9) comprises only one layer of crystals 50 and may be of any practical surface area with any practical number of crystals, limited only by the particular use or application of the article. By way of example only, the article 36 includes fifty crystals, each measuring about one millimeter square, in a backing member 38 measuring 25 mm x 25 mm x 5 mm.

If desired for some applications, multiple articles, as 36, may be bonded together in edge-to-edge coplanar relation to form a much larger surface area, not shown. Also, multiple articles may be bonded together in stacked, layered relation, also not shown. In any case, all the crystals are positioned so that their crystallographic directions are oriented in the same direction, in accordance with the principles of this invention.

### Article of Manufacture-Second Embodiment

The second embodiment of the article is identified by numeral 236 in Figs. 10 and 11. This article also conveniently includes a square backing member 238 having a mounting surface or area 240. Synthetic single diamond crystals 50, and/or 60, are used for this embodiment and are the same as used for the first embodiment in Fig. 1. As before, the crystals are preferably uniformly distributed about the mounting surface and are positioned in orthogonal and diagonal rows in a checkerboard pattern. The second embodiment differs from the first embodiment, however, in the orientation of the crystals, but this different orientation still aligns selected hardness directions.

Again, it is helpful to set forth certain crystallographic principles as a foundation for understanding the second embodiment. With reference to Fig. 12 and 13, it is known that the second hardest crystallographic direction of hardness of a diamond crystal 50 or 60 is along a line 248 which is tangential to an edge 70 of the crystal and also perpendicular to the diagonal 249 (Fig. 13) of the crystal which intersects such edge. The appropriate Miller notation for this second hardness directional line is denoted in the drawings. It will be understood that there is a similar second hardest directional line tangential and perpendicular to each edge of the crystal. It is also to be noted that the crystal 50 has another axis of symmetry represented by the diagonal 249, and that this axis passes through one edge of the crystal, through the center of the crystal, and through the opposite edge and is perpendicular to such edges.

To take advantage of this second hardest direction, the crystals 50 (Figs. 10 and 11) are individually mounted in the backing member 238 so that a dodecahedral plane of each crystal is co-planar with the mounting surface 240, or is slightly on one side or the other of such mounting surface and parallel to it. It follows, then, as best visualized in Fig. 11, that the dodecahedral plane which is perpendicular to the first-mentioned dodecahedral plane is perpendicular to said mounting surface. With such mounting, the approximate half of each crystal on one side of the mounting surface is embedded in the backing member, and the other approximate half is outside the backing member. Of greatest significance, all the exposed edges 70a, which are referred to as abrading edges, of the crystal-halves are parallel to, or in alignment with, each other; are equidistant from and parallel to the mounting surface; and together define a working surface 250 (Fig. 11). Thus, the crystals are oriented in the backing member so that their crystallographic directions of hardness as indicated by the lines 248 (Fig. 10) are aligned with, or parallel to, such directional lines of all the other crystals, depending on whether their crystals are in the same EW row 252 or in a parallel EW row.

Thus, when the abrading edges 70a (Figs. 10 and 11) of the article 236 are in contact with and moved relatively to a workpiece, not shown, in the direction of the lines 253, 254 (that is, the EW direction in Fig. 10), the combined effect of aligned hardness directions of the crystals 50 is presented to the workpiece. Although the hardness direction 248 is not the hardest direction of the crystal, it is the next-to-the-maximum hardness direction and thus allows an improved abrasive force to be applied by the crystals, as contrasted with non-aligned directions of hardness of grits, particles or crystals which are randomly positioned with regard to crystallographic direction, as practiced by the prior art.

### Method of Making the Second Embodiment of the Article

The article 236 (Fig. 10) is made in a manner similar to the article 36 (Fig. 1), except that a different template 260 (Fig. 14) is utilized to accommodate the different orientation of the crystals 50. In template 260, only a portion of which is shown in Fig. 14, recesses 264 are in the shape of an approximate cube-half, when the cube is cut along a dodecahedral or diagonal face-plane thereof. In other words, the recesses are V-shaped with a ninety degree included angle. In general, the parameters for constructing the template and the recesses are the same as for template 120 (Fig. 6). That is, the recesses are slightly larger than the crystals so as to facilitate accommodation of the crystals therein, and they have end walls 265 and side walls 266 that meet at bottom corners or edges 268 which are tangent to and lie in a common plane 270 (Fig. 15).

An alternative template 280 (Fig. 18) may be used with the second embodiment of the method. This template has V-shaped recesses, grooves or troughs 282 having side walls 284, end walls 286, and bottom edges 288, which are the same shape as the recesses 264 except that they extend almost the full length or width of the template, being enclosed by the end walls 286.

As with the method described with reference to Figs. 6-9, a similar method is followed to make the article 236 (Fig. 10). In brief, sorted, substantially uniformly sized crystals 50 are distributed in a random manner over the template 260, or 280, and the template is vibrated to cause the crystals to fall into the recesses 264, or 282. In the recesses 264, there is one crystal per recess, but with recesses 282, a line of crystals is accommodated with adjacent faces 64 of adjacent crystals preferably being in contact. Again, the templates 260 or 280 are inclined slightly and vibrated or tapped to remove excess crystals while maintaining the oriented crystals in the recesses.

Next, an uncured plastic layer 290 (Fig. 15) is placed over the template 260, or 280, to cover the protruding portions of the crystals 50 and then is allowed to cure and harden. When cured, the plastic layer becomes the backing member 238 with the crystals fixed therein and is removed from the template thereby resulting in the article 236 (Figs. 16 and 11).

### Article of Manufacture- Third Embodiment

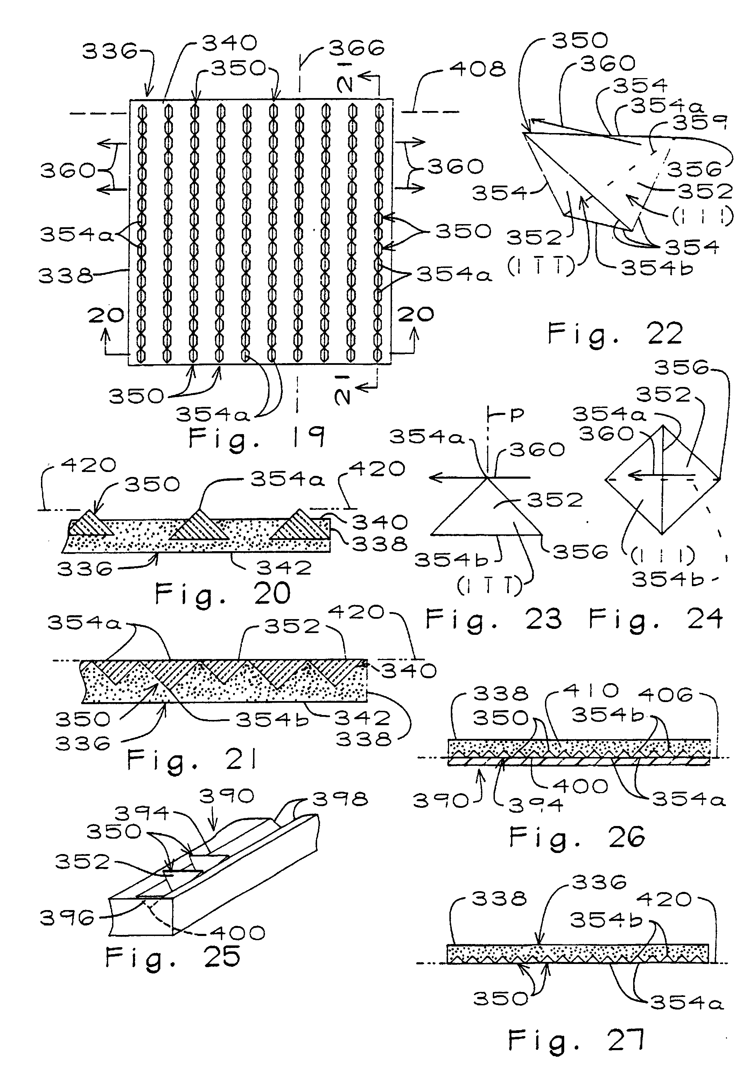

The third embodiment of this invention provides an article 336 (Figs. 19-21) similar in principle to the articles 36 and 236 of the first and second embodiments except that the third embodiment uses single, synthetic crystals 350 of cubic boron nitride (CBN). The article includes a backing member or carrier 338 for the crystals which has a mounting surface 340 and a back surface 342.

Cubic boron nitride, like diamond, is in the cubic class of crystals, but, unlike diamond, has the sphalerite structure. The CBN crystal 350 (Fig. 22) is thus a regular polyhedron like diamond but, unlike diamond, has a tetrahedral shape. Individual crystals of CBN of good quality are commercially available, with planar triangular faces 352 meeting in sharp edges 354 and corners 356, and have dimensions of up to about 0 5 mm on an edge. It is important to emphasize that, like the embodiments 36 (Fig. 1) and 236 (Fig.11) of this invention utilizing diamond crystals, the CBN used for the third embodiment is in the form of single or individual crystals and not the CBN grains used in the prior art as abrasive grains or grit that are predominately crushed aggregates of intergrown, randomly-oriented crystals. Like the other embodiments, use of single, substantially uniform crystals allows predetermination of the crystallographic directions, manipulation of the crystals, and resultant orientation into the desired positions.

As is known, the tetrahedral crystal, as 350, has several planes and axes of symmetry. One such axis is referred to in Fig. 23 by the reference letter p and is useful in describing and claiming the present invention. The axis p passes through the center of one edge of the crystal, through its center and through the center of the edge opposite to the first edge, and is perpendicular to both such edges.

No careful work is known that has correlated the variation of abrasion-resistance of the CBN crystals, as 350 (Fig. 22), with crystallographic direction. The similarity, however, between the internal atomic configurations of CBN and diamond leads to the conclusion that the most abrasive-resistant direction of a CBN crystal is along a line, as 360 (Figs. 19, 22-24), which is perpendicular to an edge, as 354a, of the crystal. This directional line may also be described as tangential to the edge 354a and parallel to the opposite edge 354b, as best illustrated in Fig. 23. It is of course understood that the edge 354a is chosen by way of example only and that there is such a directional line of maximum hardness perpendicular and tangential to each of the edges 354. Miller notations for faces of a CBN crystal are shown in the Figs. 22-24.

The crystals 350 (Figs. 19-21) are mounted in the backing member 338 so that a plane cutting through each crystal and parallel to a pair of its opposite, perpendicularly related edges lies approximately in or close to the mounting surface 340 (Fig. 20) of the backing member. Such a plane divides the crystal into two portions, so that with such a mounting; one of these portions is embedded in the backing member and the other portion is outside the backing member. In the preferred embodiment illustrated in Figs. 19-21, about sixty percent of each crystal is embedded in the backing member and the remaining forty percent protrudes out of the backing member. The important feature, however, is that the exposed edge 354a of said opposing pair of edges of each crystal is parallel with the corresponding exposed edges of all the other crystals, as is readily seen in Fig. 19, and with the mounting surface 340. Also, these edges 354a of crystals in the same NS row, as 366, are in alignment.

As previously mentioned with regard to the other embodiments, the third embodiment of the invention is not limited to the specific spacing or number of crystals 350 (Fig 19) or rows, nor to the orthogonally formed rows, nor to the number or concentration of crystals. It is important to the invention, however, that the crystallographic lines 360 of maximum hardness of corresponding edges, as 354a, of all the crystals are in alignment, or are parallel, with each other. Such alignment or parallelism of the crystallographic lines follows from mounting the crystals with the exposed edges 354a in alignment or parallel with each other.

### Method of Making the Third Embodiment of the Article

This embodiment of the method is similar to the other two method embodiments except that templates 390 and 392 (Figs. 25 and 28), similar to the templates 280 (Fig. 18) and 260 (Fig. 14), respectively, are constructed to accommodate the tetrahedral, CBN crystals. The article 336 illustrated in Fig. 19 is made using the template 390 in Fig. 25. The template 390 has elongated V-shaped recesses or troughs 394 with end walls 396, and side walls 398 meeting at predetermined angles in bottom corners or edges 400 which are all in a common plane 406 (Fig. 26).

As an example, the entire template 390, only a portion of which is shown in Fig. 25, may be approximately 32 mm x 15 mm x 5 mm in size and be made of high density polyethylene. The recesses 394 may be milled lengthwise of the template to a depth of 0.5 mm and so that the side walls 398 have an included angle of 70°32', ±5°.

With the template 390 (Fig. 25) maintained in a horizontal position, crystals 350 of CBN of pre-sorted, substantially uniform size are sprinkled on the template and thus randomly positioned thereon. By vibrating and slightly tilting the template, the crystals are caused to drop into the recesses 394 with an edge 354a (Fig. 26) of each crystal fitting against the bottom edge 400 of a recess, and thus being tangent to the common plane 406, and with two opposite side faces 352 (Fig. 25) resting against the side walls 398 of the recess and with slightly less than half of each crystal protruding outwardly from the template. Tilting the template toward one end while vibrating and tapping the same also causes excess crystals on the top surface of the template and between the recesses to drop off the template.

Epoxy resin (system three, phase two) is then poured over the template 390 so as to provide a layer 410 (Fig. 26) of 5 mm depth covering the projecting portions of the crystals 350. The resin is then cured at 60°C for two hours, causing the resin to cure and harden and form the backing member 338. The crystals are thus individually fixed in the backing member in their oriented positions in the template. The backing member and its attached crystals are then removed from the template thus resulting in article 336 (Fig. 27) wherein all of the exposed edges 354a of the crystals are parallel to each other (Fig. 19), thereby causing the crystallographic directional lines 370 of maximum hardness to be either aligned or parallel to each other and lying in the common plane of the work surface 420 (Figs. 20, 21 and 27) defined by the edges 354a. It will be understood that the coplanar relation of the edges 354a results from the bottom edges 400 of the recesses 394 lying in a common plane 406 (Fig. 26).

It will now be understood how the template 392 (Fig. 28) having spaced V-shaped recesses or pockets 426 is used to create an article, not shown, with crystals 350 temporarily placed in the pockets, individually fixed in a backing member, not shown, and then removed, to produce such an article very similar to article 236 (Fig. 10), but with CBN crystals instead of diamond crystals.

The recesses, trough or grooves 394 and 426 (Figs 25 and 28) that act as receptors of the crystals 350 to align the crystals can be chosen to be of a length slightly longer than the length of an edge of a CBN crystal, in the case of the recesses of Fig. 28, or any multiple of this length in the case of the recesses of Fig. 25. Thus, the pattern and density of the crystals can be adjusted to make optimum use of the CBN crystals for workpiece treatment.

By now it will be understood that the template, as 120, 260, 280, 390, or 392, used in the present invention is not limited to the particular recess or well configurations shown, but more broadly, the template is understood to have a receptor area shaped to accommodate and align the crystals 50 or 350, such receptor area including either a plurality of recesses or pockets or wells, as 124 or 264 or 426, or one or more troughs, as 282 or 426 or 394.

In all the embodiments of this invention, it will be understood that bonding agents other than epoxy resin or other plastic formulations may be used, as are well known in the art. Briefly, with the templates 120, 260, 280, 390, or 392 made of graphite, a powdered infiltration metal or a powdered infiltrator alloy with abrasion-resistant particles, such as tungsten carbide, can first cover the crystals 50 or 350. The assembly can then be heated to fuse the metal and create the backing member 38, 238 or 338, fixing the crystals in their oriented positions. Also, metal, such as nickel, can be electrodeposited over the crystals in the template to serve as the backing member by a well known process. Still further, any of the templates may be made of a refractory material not bondable to fired ceramic bodies, such as graphite or silicon carbide. An unfired plastic ceramic could then be layered over the crystals in the template and subsequently heated to a temperature suitable to sinter the ceramic body, whereby a vitreous backing member embeds the crystals in their oriented positions.

Figs. 29 and 30 show one of the articles, as 336, constituting part of a tool 500 which moves relatively to a workpiece 510 along a linear path 520. It will be noted that the edges 354a contact the workpiece together since they are tangential to a common plane or work surface 420. Also, the crystals all move across the workpiece perpendicularly of the edges 354a or, in other words, along the common lines 360 (Fig. 30) of directional hardness of all of the crystals. Each individual crystal engages the workpiece so that its predetermined line of maximum hardness 360 is aligned with the path 520 of movement of the crystal. Therefore, a maximum amount of abrasive action is exerted by the crystals.

Figs. 31 and 32 illustrate the principles of the present invention for use in a tool 600 which surfaces a workplace 610, shown in phantom outline in Fig. 31, along a rotary path 602. The tool comprises a sleeve 604 having an annular end 606, and a plurality of crystals, as 50, mounted on the end so that the sharp edges, as 70a, are oriented radially of the sleeve. In this manner, the crystals engage the workpiece so their individual lines 248 of high hardness are aligned with the rotary path 602 of the crystals. Although the drawing shows groups of crystals mounted at each quadrant at the end of the sleeve, the crystals can be spaced or mounted in a continuous formation about the circumference. The important point is that the crystals are mounted so that each crystal contacts the workpiece with its line of high hardness aligned with the path of movement of the crystal.

### Article of Manufacture- Fourth Embodiment

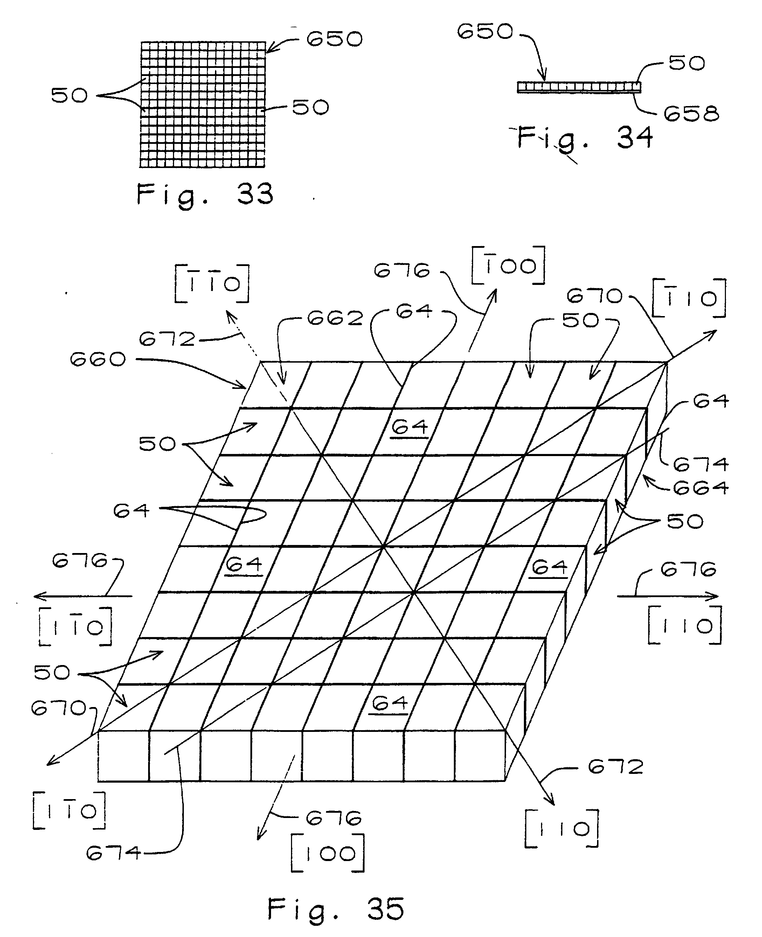

The fourth embodiment is useful as a bearing, heat sink or semiconductor. This embodiment provides an assembly 650 (Figs. 33 and 34) of synthetic single crystals 50 (or 60, although only the numeral 50 will be used in the following description) of diamond secured together in a formation by a binder 658 which forms a backing member. The crystals are oriented so as to provide the assembly with enhanced physical properties similar to what has been previously described. Full advantage of these properties cannot be realized with an individual crystal because of its minute size.

The assembly 650 of the synthetic single diamond crystals 50 shown in Figs. 33 and 34 as approximately twice actual size. In order to explain the principles of this invention as incorporated in the fourth embodiment, however, it is necessary to use illustrations considerably more enlarged from actual size than even Figs. 33 and 34. Such an enlarged assembly is indicated in Fig. 35 by reference numeral 660 and may be regarded as merely a segment of the assembly of Fig. 33.

The crystals 50 are placed in the assembly or formation 660 (Fig. 35) in an integrated, tightly packed mosaic pattern. The crystals are in side-by-side and edge-to-edge relationship with adjacent side faces 64 of adjacent crystals in mating congruent contact so as to eliminate or at least greatly reduce any gaps between the crystals and to restrict intrusion of contamination or foreign material. In the assembly, all the top faces 64 of the crystals are in a common plane which thus creates a top, outwardly directed surface 662 of the assembly, and all of the bottom faces 64 of the crystals are coplanar and define a bottom, outwardly directed surface 664.

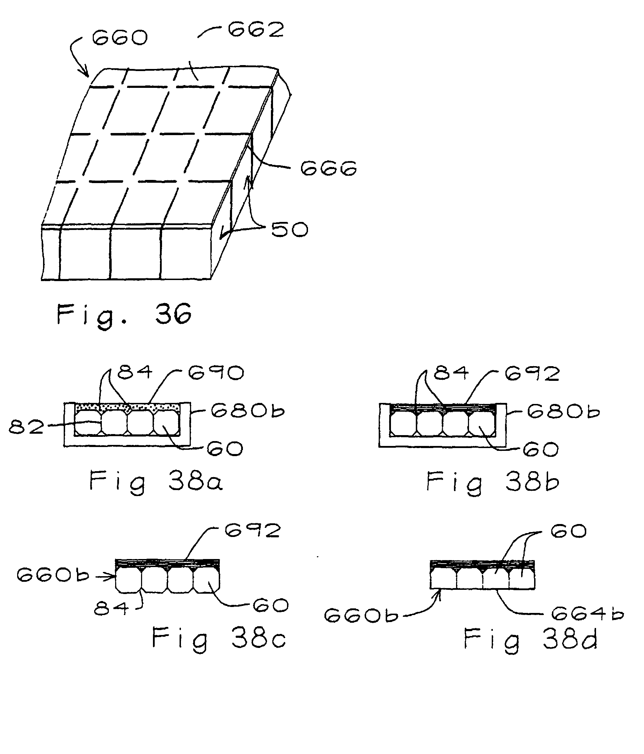

The crystals 50 are integrated or bonded together in the formation 660 by one or more of several bonding techniques, as subsequently described in greater detail. One of these bonding techniques is an adhesive coating 666 over either the top surface 662, as shown in Fig. 36, or over the bottom surface, not shown

Of greatest significance, the crystals 50 (Fig. 35), by virtue of their substantially same size and predominately cubic shape and by virtue of their described assembly 660, are oriented with their crystallographic directions of maximum abrasive resistance either aligned with, or parallel to, each other. Alignment occurs because the crystallographic directions 90, 90 ' of each crystal (Fig. 5) are aligned with the corresponding directions 90, 90' of all the other crystals lying in a row along one of the principal diagonals 670 (Fig. 35) of the assembly. Likewise, the crystallographic directions 92, 92' (Fig. 5) of the crystals lying in a row along the other principle diagonal 672 (Fig. 35) of the assembly are aligned. Parallelism occurs because these directions, as 90, 90', are parallel to such directions of the crystals in other shorter, diagonal rows, one of which is indicated by line 674 in Fig. 35.

Furthermore, the directions of minimum abrasive resistance 94, 94' (Fig. 5) are aligned and parallel to each other in a similar manner and as represented by line 676 in Fig. 35, and this line is at forty-five degrees separation from the lines of maximum resistance 670, 672.

In its basic form, the assembly or formation 650 (Fig. 33), or 660 (Fig.35), comprises only one layer of crystals 50 and may be of any practical surface area, that is, any practical number of crystals, limited only by the assembly space and the particular use or application of the assembly. By way of example only, the assembly in Fig. 33 includes two-hundred twenty-five crystals with an actual size of approximately fifteen millimeters by fifteen millimeters square and slightly in excess of one millimeter thick allowing for the thickness of the binder 658. In contrast, the assembly of Fig. 35 includes sixty-four crystals and would measure 8 by 8 by 1 mm in actual size.

The perimeter or outside edge of the assembly 650 need not be rectangular and may have other regular or irregular configurations since the principles of the invention still apply along the diagonals of the assembly as governed by the cubic crystal faces 64 (Fig. 35) within the margins of the assembly. Again, reference to top and bottom surfaces 662 and 664 does not imply use of the assembly in any particular orientation but is for convenience in describing the assembly of the crystals 50. If desired for some applications, multiple assemblies, not shown, may be bonded together in edge-to-edge coplanar relation to form a much larger surface area. Also, multiple assemblies may be bonded together in stacked, layered relation, also not shown. In any case, the crystals are assembled so that their crystallographic directions are oriented in the same direction, in accordance with the principles of this invention. Multiple layers also occur upon chemical vapor deposition, as subsequently described.

### Method of Making the Fourth Embodiment of the Article

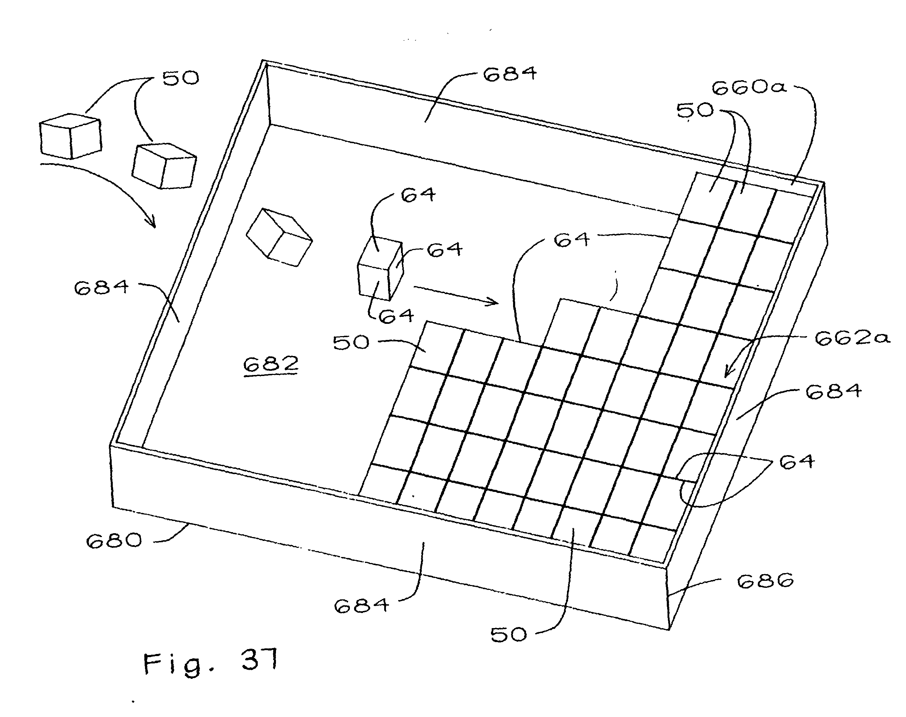

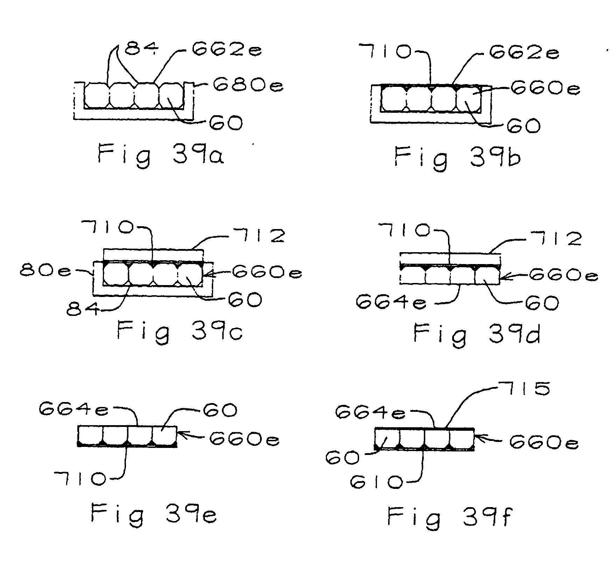

In general, the method of making the fourth embodiment may be divided into two parts for descriptive purposes, namely, initially assembling the crystals 50 so as to form the assembly 650, and secondly, binding the crystals in the assembly. Figs 37 illustrates the steps of assembling the crystals, and Figs. 38 and 39 illustrate two embodiments of binding the crystals in the assembly.

The initial part of the method, namely, placing the diamond crystals 50 in an assembly 660a is thus described by reference to Fig. 37. One of the first tasks is to select the crystals to be used. Synthetic single diamond crystals of subtantially cubic shape, or of cubo-octahedral shape where the cubic faces predominate, are chosen. Also, the crystals used should be of substantially the same size. Currently, crystals are available up to about 1 mm on an edge, but as synthetic growing techniques improve, larger crystal sizes may become available. If not already accomplished, and as discussed above, the supply acquired should be sized to insure that the crystals used are of substantially the same size, preferably from 0.75 mm to 1 mm or larger if available. As previously noted, only perfectly cubic crystals 50 are shown in Fig. 37, but the method described is equally applicable to the cubo-octahedral crystals 60 with predominately cubic faces 82.

Synthetic, single diamond crystals 50 are dropped (Fig. 37) one at a time or in limited numbers into a tray or receptacle 680 having a planar bottom surface 682 and side walls 684 defining a corner 686 of the tray which has the shape of a corner of a cube. The tray is tilted toward the corner and is gently shaken, vibrated or tapped in the plane of the bottom surface. When the crystals land on the bottom surface 682, they attain a stable position on one of their faces 64. Stability occurs because of the cubic shape of each crystal; the angle of tilt of the tray; the mass of the crystal; and the material of the tray, more particularly the bottom surface 682. Then, because of the tilt and vibration of the tray, the crystals slide toward the corner. The angle of tilt of the tray and the vibrating action are adjusted to achieve this stabilization and sliding action. In the described embodiments, the tray is preferably made of high density polyethelene, PTFE, graphite, a refractory, or other material which has a coefficient of friction to promote the described stabilty and sliding action of the diamond crystals.

As the crystals 50 slide into the corner 686 of the tray 680 (Fig. 37), they align themselves with the side walls 684 of the tray or with the side faces 64 of crystals that are already in oriented positions in the corner and thereby build up the assembly 660a of crystals in a layer, one crystal thick. Use of needle point tweezers, not shown but commonly available, may be used to reposition any errant crystals. The side faces of adjacent crystals are in congruent contact with each other, and the top faces of all the crystals in the assembly form the common planar surface 662. This results in all the crystals being oriented in the same crystallographic direction, as explained above in describing the assembly 660 in Fig. 35.

After the crystals 50 are positioned in the assembly 660a (Fig. 37), they are bound together in accordance with the second part of the method, now described with reference to the two embodiments shown in Figs. 38 and 39. In describing these embodiments, all of the crystals are shown as cubo-octahedral crystals 60 with predominately cubic faces 82, but it is understood that in actual use, the crystals may be a mixture of cubic crystals 50 and such cubo-octahedral crystals 60. Only cubo-octahedral crystals are shown in Figs. 38 and 39 because of illustrative convenience and because it facilitates description of the binding and grinding steps.

With reference first to Fig. 38a through 38d, the steps are described for binding crystals 50 in an assembly 660b which has utility for abrasion resistance in bearings and heat sink purposes. It is noted that Figs. 38 and 39 are schematic views involving only a few crystals and are intended primarily to show the principles of the method. Cubo-octahedral synthetic single diamond crystals 60 (Fig. 38a) with large cubic faces 82 and relatively small octahedral facets 84 and approximately one millimeter in size are contained and oriented in a tray 680b, for example in the manner discussed with reference to Fig. 37. The crystals in the tray are then covered with a metal infiltration powder 690, such as Macrofil, a product available from Kennametal Inc. of Latrobe, Pennsylvania, USA that is capable of wetting the crystals upon heating. The powder is then heated to melting temperature to fuse the metal to the surface of the crystals and to draw it by capillary action into interstices between the top corners or octahedral facets 84 of the crystals. It is to be understood that the tray is made of a heat-resistant material, such as graphite, which is not wetted by the metal. The molten metal is then allowed to cool and solidify to form a binder coating 692 (Fig. 38b), whereupon the crystal assembly is removed from the tray (Fig. 38c). Finally, the bottom surface 664b of the assembly is ground to remove the octahedral facets and to produce a smooth coplanar surface.

The embodiment of the method described and illustrated in Figs. 37 and 38a-38d produces the bearing surface 664b which has a maximum abrasive resistant direction along the aligned diagonals of the crystals 60, as fully described above in discussing Fig. 35. Using the principles of Figs. 37 and 38a-38d, an article, as 650 (Fig. 33), is produced which is useful as a bearing member with an exceptionally high abrasion resistance along the defined direction. It is significant to note, however, that the method also causes, and the article exhibits, a direction of minimum abrasive resistance, and it is along this line that the grinding occurs in achieving the smooth planar surface 664b. Thus, by following the principles of this invention, both maximum and minimum abrasive directions are fully achieved and exploited.

In addition, the article of the fourth embodiment is useful as a heat sink since the cubic faces 82 of the crystals 60 are in intimate contact and allow maximum heat conductivity across the interfaces of the crystals. The metal binder 692 enters essentially only the interstices between the octahedral facets 84 of the crystals and thus does not contaminate the main body of the assembly and interfere with the excellent thermal conductivity of diamond. The bearing surface or heat sink can be enlarged by including more crystals in the assembly 650 or by duplicating the assembly and mounting the assemblies so provided in contiguous edge-to-edge generally coplanar relationship to form a larger assembly of crystals, as will be understood although not shown.

Figs. 39a through 39f are referred to in describing another embodiment of the binding part of the method of the present invention so as to provide an article of manufacture suitable for electronic, heat sink, or abrasion-resistant uses. In Fig. 39a, the crystals 60 are assembled as previously described in a tray or box 680e which is temperature resistant to 1000° C and chemically resistant to chemical vapor deposition (CVD) of diamond. For this purpose a suitable tray material is refractory cement. A first coat 710 (Fig. 39b) of diamond is deposited by CVD on the upper surface 662d which binds the crystals 60 together in assembly 660e. While the assembly is still in the tray (Fig. 39c), a rigid backing 712, which may be made of plate glass or aluminum, is temporarily cemented, for example by lapidarist's cement such as stick shellac, to the first coat 710 of diamond to hold the assembly 660e rigidly together to allow grinding. Next, the assembly of diamond crystals as held together by the rigid backing is removed from the tray (Fig. 39d), and the lower surface 664e is finished by a grinding tool, by chemical milling, or by laser machining to provide a smooth coplanar surface 664e with any octahedral facets 84 destroyed.

In the next step (Fig. 39e), the backing 712 and the cement used to attach it are removed by dissolution with a solvent, such as alcohol, or by heating to a temperature of approximately 200°C. Many other temporary cements could also be used and dissolved. A second coat 715 (Fig. 39f) of diamond is then deposited by CVD over the planar surface 664e. It is to be understood that the diamond in both the first and second coats 710 and 715 inherits the orientation of the atomic arrangement of the oriented diamond crystals in the assembly 660e so that the final article is an assembly of pure, single crystal diamond, with all of the crystallographic directions oriented in the same direction. The article 660e is thus ideally suited for the semiconductor, heat sink and bearing purposes discussed herein.

In summary of the present invention and its advantages, each of the described embodiments comprises synthetic single crystals of diamond or CBN, as 50, 60 and 350, held in a formation with selected crystallographic directions of the crystals oriented in the same direction. In the first three embodiments, a plurality of single synthetic crystals of diamond or CBN of substantially uniform size and shape are mounted in a backing member, as 38, 238 and 338, so that all the crystals are oriented with corresponding hard-to-abrade directions aligned. With the first and third embodiments in Figs. I and 19, the hardest-to-abrade directions are aligned, whereas with the second embodiment of Fig. 10, the next-to-the hardest directions are aligned. In all four embodiments the exposed workpiece-engaging extremities, as 64, 70a, 354a, 64b of the crystals lie in a common plane for simultaneous workpiece engagement even though some of the crystals are of slightly differing sizes. With the second and third embodiments of Figs.10 and 19, sharp edges, as 70 and 354, are presented to a workpiece, and with the variation of the first embodiment (Fig. 7), sharp corners, as 74, are presented. In the embodiments of Figs. 7, 10, 19, therefore, the sharp edges or sharp corners are in a saw-tooth formation which together with the aligned hardness directions produce an especially effective abrading action. It is also to be noted that the spacing between the crystals facilitates removal of abraded material as a workpiece is being processed.

From the foregoing, the following advantages, inter alia, of the first three embodiments will be understood. Since only the hardest-to-abrade directions are presented to a workpiece, the abrasive article: has increased life thus saving abrasive material; abrades faster; requires less frequent replacement of parts; maintains dimensional tolerances longer; minimizes adjustment for wear compensation; reduces dulling and flatting; and allows variation of abrasive concentration and thus facilitates its optimization. Furthermore, since all of the workpiece-engaging extremities of the crystals lie in a common plane, even though the individual crystals may vary somewhat in length, the crystals engage the workpiece simultaneously and uniformly thereby enabling uniform removal of material from the workpiece and avoiding the problems of grains which stand high and slow the abrasive action. All of the above stated features and advantages have the effect of reducing cost, time and labor and improving abrasive action.

The terms "abrasive" and "abrading" are sometimes used in the art in a very specific sense to mean a very specific type of workpiece treating action. It is to be understood, however, that as used herein, these terms are not limited to such a specific meaning but include cutting, grinding, dressing, lapping, sawing, or otherwise treating or engaging workpieces in the multitude of ways in which a hard surface or tool is used. It is also to be noted that the principles of the invention are more broadly applicable to wear-resistant surfaces which are useful not only as workpiece-treating elements but as bearing elements.

In addition, it will be understood from the foregoing that the fourth embodiment yields the following advantages. The alignment of the hardest-to-abrade direction, that is the cube face diagonal of diamond crystals, gives superior wear surface, as compared to bonded aggregations of randomly oriented diamond crystals, because of the presentation of the one hundred percent hardest directions and the absence of a softer bonding agent. This is an advantage in sliding-surface bearings or thrust bearings especially in applications with abrasive contamination between the wear surfaces. The reduction in wear lengthens the time between bearing replacement or adjustment, retains the dimensional tolerances between bearing surfaces for longer periods, and retains the smoothness of bearing surfaces for longer periods of service. Friction values of the hardest-to-abrade diamond directions on each other are lower than friction values for random diamond directions. The result is less heat generation, lower power consumption, and less stress on the bearing parts.

The high heat conductivity of diamond makes a superior heat sink to conduct heat away from the heat source. The subject invention produces an extended assembly 650 with almost one hundred percent diamond content, and thus a continuous homogeneous content of diamonds without the diluting effect of binders used in binding diamond crystals.

The fourth embodiment produces an extended, voidless assembly 650 of diamond crystals with identical crystallographic directions. Chemical vapor deposition on the assembly results in a thin layer of diamond with one crystallographic direction because of the epitaxial relationship between the chemically-vapor deposited layer and the substrate of oriented diamond crystals. It is important to regognize that the assembly has one crystallographic direction yielding single crystal quality because the contacting adjacent crystals avoids spaces between the crystals which would otherwise produce defects at the growth boundaries.

Following the principles of the fourth embodimen thus makes possible improved exploitation of diamond's semiconductor properties. Chemically-vapor deposited single-crystal assemblies, as 660e, can be made insulating in character by using pure diamond or can be doped with impurities to yield P or N carriers to make diodes, transistors, radiation detectors, or photo conductor devices. The diamond substrate forms an integral heat sink to allow increased electric current capacity to the devices, and diamond's high temperature and chemical immunity permit devices to function in hostile environments.

In attrition grinding of hard materials to reduce particles to smaller sizes, the wear of machine surfaces by the abrasive action of the particles is costly because the parts wear rapidly and must be replaced, and the parts that wear produce particles that contaminate the product being ground. By applying to the wear surfaces, assemblies or layers 650 of aligned diamond crystals that present the hard-to-abrade directions of the crystals to the abrading directions of the particles being ground, machine wear can be drastically reduced thus saving the cost of new wear surfaces and the cost of replacing them. The great reduction of impurities from wear surfaces is often of critical importance in quality control, and the minuscule contamination by diamond wear surfaces is of a highly inert nature.

The present invention takes advantage of the inherent properties of diamonds and particularly synthetic diamond crystals in the manner described, but it is to be understood that the principles of this invention are equally applicable to other materials that have similar or equivalent crystalline properties.

In addition to the terms "assembly" and "formation," the terms "array," "sheet," "mosaic," "block," and "matrix" are used to describe the article of manufacture provided by the present invention. Other terms could be used without affecting the principles described herein. It is understood that the use of these terms does not imply any particular surface area or size of the various assemblies shown in Figs. 1, 10, 19 or 33.

Furthermore, although preferred embodiments have been shown and described, various modifications and substitutions may be made thereto without departing from the scope of the invention. Accordingly, it is to understood that the present invention has been described by way of illustration and not limitation.

## Claims

1. An abrasive article (36, 236, 336) comprising a backing member (38, 238, 338) having amounting surface (40, 240, 340) a group of synthetic single crystals (50, 350) secured to the backing member in spaced relationship and distributed over said mounting surface, each of said crystals being a polyhedron with side faces meeting in edges of the crystal, each crystal also having predetermined directions of hardness (90, 92, 248, 249) along lines in the plane of each face and tangential to each edge, the article being **characterized in that**:
the faces and edges constitute abrading portions of the crystals, and
the crystals are oriented on the backing member with a selected abrading portion of each crystal projecting outwardly from the mounting surface (40, 240, 340) with all the corresponding lines of hardness being either in alignment or parallelism so that the group of crystals exhibits a common direction of hardness.

2. The article of Claim 1, wherein the crystals (50) are diamond of cubic shapes and uniform size, each crystal thereby having square face portions meeting in edge portions, being further **characterized in that**:
the face (64) and edge portions (70) constitute the abrading portions of the crystals, and all of said selected abrading portions project equidistantly outwardly from the mounting surface.

3. The article of Claim 1, being further **characterized in that**:
one of the face portions of each crystal is the selected abrading portion.

4. The article of Claim 3, being further **characterized in that**:
each abrading portion has corners, and
one corner of each abrading portion projects farther outwardly from said mounting surface than the other corners thereof to provide a plurality of sharp abrading elements.

5. The article of Claim 1, being further **characterized in that**:
one of the edge portions (70a) of each crystal is the selected abrading portion.

6. The article of Claim 1, wherein the crystals (350) are cubic boron nitride of tetrahedral shapes and of uniform size, each crystal thereby having triangular faces meeting in edges of the crystal, being further **characterized in that**:
one edge (354a) of each crystal is its abrading portion.

7. The article of Claim 6, being further **characterized in that**:
all of the abrading portions project equidistantly outwardly from said mounting surfaces and constitute said selected portions of the crystals.

8. A method for producing abrasive articles from a plurality of synthetic single crystals of the same polyhedral shape and of the same size wherein each of said crystals has at least one portion having a crystallographic direction of hardness which is the same in all of the crystals, **characterised by** said at least one portion being a workpiece-engaging portion, and the steps of:
orienting the crystals to position and align said workpiece-engaging portions of each article so that all of said predetermined crystallographic directions of hardness are aligned and whereby said workpiece-engaging portions collectively exhibit a common crystallographic direction of hardness; and
securing the crystals together as positioned and aligned in said orienting step so that said workpiece-engaging portions are positioned to collectively engage a workpiece.

9. The method of Claim 8, further **characterized in that**:
the orienting step (a) includes, positioning the workpiece-engaging portions so as to be tangential to a common plane.

10. The method of Claim 8, further **characterized in that**:
each of the crystals has faces meeting in edges, wherein a face of each crystal is a workpiece-engaging face and constitutes said workpiece-engaging portion of the crystal, each of said workpiece-engaging faces having a crystallographic direction of maximum hardness in the plane of the face and lying along a diagonal thereof, and
wherein said orienting step orients said workpiece-engaging faces with said crystallographic directions of maximum hardness either parallel to or colinear with each other, whereby all of said crystallographic directions of maximum hardness are aligned in the same direction and the crystals of the article collectively exhibit a common crystallographic direction of maximum hardness.

11. The method of Claim 8, further **characterized in that**:
each of the crystals has faces meeting in edges, wherein an edge of each crystal is a workpiece-engaging edge and constitutes said workpiece-engaging portion of the crystal, each of said workpiece-engaging edges having a crystallographic direction of hardness lying along a line tangential to its workpiece-engaging edge, and
wherein said orienting step orients said workpiece-engaging edges with said crystallographic directions of hardness either parallel to or colinear with each other, whereby all of said crystallographic directions of hardness are aligned in the same direction and the crystals of the article collectively exhibit a common crystallographic direction of hardness.

12. The method of claim 8, further **characterized in that**:
step (a) includes assembling the crystals in a generally coplanar formation.

13. The method of claim 8, further **characterized in that**:
the crystals are selected from the group consisting of diamond and CBN:

14. The method of claim 8, being further **characterized in** the steps of:
(a) as part of the orienting step, introducing said workpiece-engaging portions of the crystals into a template having a receptor means shaped to position and align said workpiece-engaging portions to collectively exhibit a common crystallographic direction of hardness and wherein said crystals protrude from said template,
(b) vibrating the template to stabilize the crystals in the receptor means and to remove excess crystals,
c) applying a binder to the crystals protruding from the template whereby the crystals are fixed in the positions in which they were aligned in the template,
(d) at least partially curing said binder, and
(e) removing the crystals and binder from the template.

15. The method of Claim 14, further **characterized in that** the receptor means is a plurality of receptor wells shaped to correspond to the workpiece-engaging portion of each crystal and wherein said workpiece-engaging portions are received into said wells during steps (a) and (b).

16. The method of Claim 14, further **characterized in that** the workpiece-engaging portion of each crystal is a cubic of the crystal, wherein the receptor wells are shaped to receive the workpiece-engaging portions therein and thus have bottom walls and upstanding side walls, and wherein said workpiece-engaging portions of the crystals fit into the receptor wells against the bottom walls thereof during steps (a) and (b).

17. The method of Claim 14, further **characterized in that** the workpiece-engaging portion of each crystal is a V-shaped cutting edge and the receptor wells are complementary to said cutting edges, and wherein the V-shaped cutting edges fit into the receptor wells during steps (a) and (b).

18. The method of Claim 14, further **characterized in that** said abrasive crystals are seleted from the group consisting of diamond and CBN.

## Patentansprüche

1. Schleifartikel (36, 236, 336), der ein Versteifungselement (38, 238, 338) mit einer Bettungsoberfläche (40, 240, 340) eine Gruppe von an dem Versteifungselement in voneinander beabstandeter Beziehung befestigten und über die Bettungsoberfläche verteilten synthetischen Einzelkristallen (50, 350) umfasst, wobei jedes der Kristalle ein Polyeder mit sich an Kanten des Kristalls treffenden Seitenflächen ist und jedes Kristall auch vorgegebene Härterichtungen (90, 92, 248, 249) entlang von Linien in der Ebene jeder Fläche und tangential zu jeder Kante aufweist, wobei der Artikel **dadurch gekennzeichnet ist, dass**:
die Flächen und Kanten abschleifende Bereiche der Kristalle bilden und die Kristalle auf dem Versteifungselement so orientiert sind, dass ein ausgewählter abschleifender Bereich jeden Kristalls von der Bettungsoberfläche (40, 240, 340) nach außen vorragt, wobei alle entsprechenden Härtelinien entweder ausgerichtet oder parallel sind, so dass die Gruppe der Kristalle eine gemeinsame Härterichtung zeigt.

2. Artikel nach Anspruch 1, wobei die Kristalle (50) Diamanten kubischer Form und einheitlicher Größe sind, wodurch jedes Kristall sich in Kantenbereichen treffende quadratische Flächenbereiche aufweist, weiter **dadurch gekennzeichnet, dass**:
die Fläche (64) und Kantenbereiche (70) die abschleifenden Bereiche der Kristalle bilden und alle ausgewählten abschleifenden Bereiche äquidistant von der Bettungsoberfläche nach außen vorragen.

3. Artikel gemäß Anspruch 1, weiter **dadurch gekennzeichnet, dass**:
einer der Flächenbereiche jeden Kristalls der ausgewählte abschleifende Bereich ist.

4. Artikel nach Anspruch 3, weiter **dadurch gekennzeichnet, dass**:
jeder abschleifende Bereich Ecken hat und
eine Ecke jedes abschleifenden Bereichs weiter von der Bettungsoberfläche nach außen vorragt als dessen andere Ecken, um eine Mehrzahl von scharfen abschleifenden Elementen Bereit zu stellen.

5. Artikel nach Anspruch 1, weiter **dadurch gekennzeichnet, dass**:
einer der Kantenbereiche (70a) jeden Kristalls der ausgewählte abschleifende Bereich ist.

6. Artikel nach Anspruch 1, wobei die Kristalle (350) kubisches Bornitrid tetraedrischer Formen und einheitlicher Größe sind, wodurch jedes Kristall sich an den Kanten des Kristalls treffende, dreieckige Flächen aufweist, weiter **dadurch gekennzeichnet, dass**:
eine Kante (354a) jeden Kristalls sein abschleifender Bereich ist.

7. Artikel nach Anspruch 6, weiter **dadurch gekennzeichnet, dass**:
alle abschleifenden Bereiche äquidistant von den Bettungsoberflächen nach außen vorragen und die ausgewählten Bereiche der Kristalle bilden.

8. Verfahren zur Herstellung von Schleifartikeln aus einer Mehrzahl synthetischer Einzelkristalle von gleicher polyedrischer Form und gleicher Größe, wobei jedes der Kristalle zumindest einen Bereich hat, der eine kristallographische Härterichtung aufweist, die in allen Kristallen die selbe ist, **dadurch gekennzeichnet, dass** der zumindest eine Bereich ein Werkstück-kontaktierender Bereich ist, und durch die Schritte:
Orientieren der Kristalle, um die Werkstück-kontaktierenden Bereiche jedes Artikels zu positionieren und auszurichten, so dass alle vorgegebenen kristallographischen Härterichtungen ausgerichtet sind und wodurch die Werkstück-kontaktierenden Bereiche zusammen eine gemeinsame kristallographische Härterichtung zeigen; und
Befestigen der Kristalle miteinander, wie in dem Orientierungsschritt positioniert und ausgerichtet, so dass die Werkstück-kontaktierenden Bereiche positioniert sind, um zusammen ein Werkstück zu kontaktieren.

9. Verfahren nach Anspruch 8, weiter **dadurch gekennzeichnet, dass**:
der Orientierungsschritt (a) derartiges Positionieren der Werkstück-kontaktierenden Bereiche beinhaltet, dass sie tangential zu einer gemeinsamen Ebene sind.

10. Verfahren nach Anspruch 8, weiter **dadurch gekennzeichnet, dass**:
jede der Kristalle sich in Kanten treffende Flächen aufweist, wobei eine Fläche jeden Kristalls eine Werkstück-kontaktierende Fläche ist und den Werkstück-kontaktierenden Bereich des Kristalls bildet, jede der Werkstück-kontaktierenden Flächen eine in der Ebene der Fläche und längs einer ihrer Diagonalen liegende kristallographische Richtung maximaler Härte aufweist und der Orientierungsschritt die Werkstück-kontaktierenden Flächen mit den kristallographischen Richtungen maximaler Härte entweder parallel oder kolinear zueinander orientiert, wodurch alle kristallographischen Richtungen maximaler Härte in derselben Richtung ausgerichtet sind und die Kristalle des Artikels zusammen eine gemeinsame kristallographische Richtung maximaler Härte zeigen.

11. Verfahren nach Anspruch 8, weiter **dadurch gekennzeichnet, dass**:
jede der Kristalle sich in Kanten treffende Flächen aufweist, wobei eine Kante jeden Kristalls eine Werkstück-kontaktierende Kante ist und den Werkstück-kontaktierenden Bereich des Kristalls bildet, jede der Werkstück-kontaktierenden Kanten eine längs einer zu ihrer Werkstück-kontaktierenden Kante tangentiale Linie liegende kristallographische Härterichtung aufweist und der Orientierungsschritt die Werkstück-kontaktierenden Kanten mit den kristallographischen Härterichtungen entweder parallel oder kolinear zueinander orientiert, wodurch alle kristallographischen Härterichtungen in derselben Richtung ausgerichtet sind und die Kristalle des Artikels zusammen eine gemeinsame kristallographische Härterichtung zeigen.

12. Verfahren nach Anspruch 8, weiter **dadurch gekennzeichnet, dass**:
Schritt (a) das Zusammenbauen der Kristalle in einer allgemein koplanaren Struktur beinhaltet.

13. Verfahren nach Anspruch 8, weiter **dadurch gekennzeichnet, dass**:
die Kristalle ausgewählt sind aus der Gruppe, die aus Diamant und CBN besteht.

14. Verfahren nach Anspruch 8, weiter durch die Schritte gekennzeichnet:
(a) Als Teil des Orientierungsschritts, Einführen der Werkstück-kontaktierenden Bereiche der Kristalle in eine Schablone, die ein Aufnahmemittel hat, das zum Positionieren und Ausrichten der Werkstück-kontaktierenden Bereiche ausgeformt ist, so dass sie zusammen eine gemeinsame kristallographische Härterichtung zeigen und wobei die Kristalle aus der Schablone herausragen;
(b) Vibrieren der Schablone, um die Kristalle im dem Aufnahmemittel zu stabilisieren und überschüssige Kristalle zu entfernen,
c) Aufbringen eines Bindemittels auf die aus der Schablone herausragenden Kristalle, wodurch die Kristalle in den Positionen fixiert werden, in denen sie in der Schablone ausgerichtet worden sind,
(d) zumindest teilweises Aushärten des Bindemittels, und
(e) Entnehmen der Kristalle und des Bindemittels aus der Schablone.

15. Verfahren nach Anspruch 14, weiter **dadurch gekennzeichnet, dass** das Aufnahmemittel eine Mehrzahl von Aufnahmevertiefungen ist, die so ausgeformt sind, dass sie dem Werkstück-kontaktierenden Bereich jedes Kristalls entsprechen und wobei die Werkstück-kontaktierenden Bereiche während der Schritte (a) und (b) in den Vertiefungen aufgenommen sind.

16. Verfahren nach Anspruch 14, weiter **dadurch gekennzeichnet, dass** der Werkstück-kontaktierende Bereich jeden Kristalls eine kubische Fläche des Kristalls ist, wobei die Aufnahmevertiefungen so ausgeformt sind, dass sie die Werkstück-kontaktierenden Bereiche darin aufnehmen und daher Bodenwände und aufrechte Seitenwände haben und wobei die Werkstück-kontaktierenden Bereiche der Kristalle während der Schritte (a) und (b) in die Aufnahmevertiefungen gegen deren Bodenwände passen.

17. Verfahren nach Anspruch 14, weiter **dadurch gekennzeichnet, dass** der Werkstück-kontaktierende Bereich jeden Kristalls eine V-förmige Schneidkante ist und die Aufnahmevertiefungen zu diesen Schneidkanten komplementär sind und wobei die V-förmigen Schneidkanten während der Schritte (a) und (b) in die Aufnahmevertiefungen passen.

18. Verfahren nach Anspruch 14, weiter **dadurch gekennzeichnet, dass** die Schleifkristalle aus der Gruppe ausgewählt sind, die aus Diamant und CBN besteht.

## Revendications

1. Article abrasif (36,236,336) comprenant un élément d'appui (28,238,338) comportant une surface de montage (40,240,340) un groupe de monocristaux synthétiques (50,350) fixés sur l'élément de support en relation espacée et répartis sur ladite surface de montage, chacun desdits cristaux étant un polyhèdre avec les faces latérales rejoignant les arêtes du cristal, chaque cristal ayant des directions prédéterminées de dureté (90,92,248,249) le long de lignes dans le plan de chaque face et tangentielles à chaque arête,
l'article étant **caractérisé en ce que**:
les faces et les arêtes constituent des portions abrasives des cristaux, et les cristaux sont orientés sur l'élément de support avec une portion abrasive sélectionnée de chaque cristal faisant saillie vers l'extérieur à partir de la surface de montage (40,240,340) avec toutes les lignes correspondantes de dureté qui se trouvent en alignement ou en parallèle de sorte que le groupe de cristaux présente une direction commune de dureté.

2. Article selon la revendication 1, dans lequel les cristaux (50) sont des diamants de forme cubique et de taille uniforme, chaque cristal ayant ainsi des portions de faces carrées rejoignant les portions d'arête, étant de plus **caractérisé en ce que**:
la face (64) et les portions d'arête (70) constituent les portions abrasives des cristaux et toutes lesdites portions abrasives sélectionnées faisant saillie de façon équidistante vers l'extérieur à partir de la surface de montage.

3. Article selon la revendication 1, étant de plus **caractérisé en ce que**:
l'une des portions de face de chaque cristal est la portion abrasive sélectionnée.

4. Article selon la revendication 3, étant de plus **caractérisé en ce que**:
chaque portion abrasive présente des coins, et
un coin de chaque portion abrasive fait davantage saillie vers l'extérieur à partir de ladite surface de montage que les autres coins de celle-ci pour donner une pluralité d'éléments abrasifs aigus.

5. Article selon la revendication 1, **caractérisé de plus en ce que**:
l'une des portions d'arête (70a) de chaque cristal est la portion abrasive sélectionnée.

6. Article selon la revendication 1, dans lequel les cristaux (350) sont en nitrure de bore cubique en forme de tétrahèdre et de taille uniforme, chaque cristal ayant ainsi des faces triangulaires en contact avec les arêtes du cristal, étant de plus **caractérisé en ce que** :
une arête (354a) de chaque cristal constitue sa portion abrasive.

7. Article selon la revendication 6, étant de plus
**caractérisé en ce que**:
toutes les portions abrasives font saillie de façon équidistante vers l'extérieur à partir desdites surfaces de montage et constituent lesdites portions sélectionnées des cristaux.

8. Procédé pour la production d'articles abrasifs à partir d'une pluralité de monocristaux synthétiques de la même forme de tétrahèdre et de la même taille, dans lequel chacun desdits cristaux présente au moins une portion ayant une direction cristallographique de dureté qui est la même dans tous les cristaux, **caractérisé par** la dite au moins une portion étant une portion d'engagement de la pièce à usiner, et les étapes consistant à :
orienter les cristaux pour positionner et aligner lesdites portions d'engagement de la pièce à usiner de chaque article de sorte que toutes lesdites directions cristallographiques prédéterminées de dureté sont alignées et ainsi lesdites portions d'engagement de la pièce à usiner présentent collectivement une direction cristallographique commune de dureté; et
assujettir les cristaux ensemble de la manière dont ils sont positionnés et alignés dans ladite étape d'orientation de sorte que lesdites portions d'engagement de la pièce à usiner sont positionnées pour coopérer collectivement avec une pièce à usiner.

9. Procédé selon la revendication 8, **caractérisé de plus en ce que**:
l'étape d'orientation (a) comprend le positionnement des portions d'engagement de la pièce à usiner de façon à être tangentielles à un plan commun.

10. Procédé selon la revendication 8, **caractérisé de plus en ce que**:
chacun des cristaux présente des faces rejoignant les arêtes, dans lequel une face de chaque cristal est une face d'engagement de la pièce à usiner et constitue ladite portion d'engagement de la pièce à usiner du cristal, chacune desdites faces d'engagement de pièce à usiner ayant une direction cristallographique de dureté maximum dans le plan de la face et se situant le long de sa diagonale, et
dans laquelle ladite étape d'orientation oriente lesdites faces d'engagement de la pièce à usiner avec lesdites directions cristallographiques de dureté maximum de façon parallèle ou colinéaire entre elles, tandis que toutes lesdites directions cristallographiques de dureté maximum sont alignées dans la même direction et les cristaux de l'article présentent collectivement une direction cristallographique commune de dureté maximum.

11. Procédé selon la revendication 8, **caractérisé de plus en ce que**:
chacun des cristaux présente des faces rejoignant les arêtes, dans lequel une arête de chaque cristal est une arête d'engagement de la pièce à usiner et constitue ladite portion d'engagement de la pièce à usiner du cristal, chacune desdites arêtes d'engagement de la pièce à usiner ayant une direction cristallographique de dureté se situant le long d'une ligne tangentielle à son arête d'engagement de la pièce à usiner, et dans lequel ladite étape d'orientation oriente lesdites arêtes d'engagement de la pièce à usiner avec lesdites directions cristallographiques de dureté de façon parallèle ou de façon colinéaire entre elles, de sorte que toutes lesdites directions cristallographiques de dureté sont alignées dans la même direction et les cristaux de l'article présentent collectivement une direction cristallographique commune de dureté.

12. Procédé selon la revendication 8, **caractérisé en ce que**:
l'étape (a) comprend l'assemblage des cristaux dans une formation généralement coplanaire.

13. Procédé selon la revendication 8, **caractérisé de plus en ce que**:
les cristaux sont sélectionnés dans le groupe consistant en diamant et nitrure de bore cubique (CBN).

14. Procédé selon la revendication 8, **caractérisé de plus par** les étapes consistant à:
a) en tant que partie de l'étape d'orientation, introduire ladite portion d'engagement de pièce à usiner des cristaux dans un gabarit comportant des moyens de récepteur configurés pour positionner et aligner lesdites portions d'engagement de pièce à usiner pour présenter collectivement une direction cristallographique commune de dureté et dans lequel lesdits cristaux font saillie à partir du gabarit,
b) faire vibrer le gabarit pour stabiliser les cristaux dans les moyens de récepteur et pour enlever les cristaux en excédent,
c) appliquer un liant aux cristaux faisant saillie à partir du gabarit de sorte que les cristaux sont assujettis dans les positions où ils étaient alignés dans le gabarit,
d) sécher au moins partiellement ledit liant, et
e) enlever les cristaux et le liant du gabarit.

15. Procédé selon la revendication 14, **caractérisé de plus en ce que** les moyens de récepteur sont constitués par une pluralité de puits de récepteur configurés pour correspondre à la portion d'engagement de la pièce à usiner de chaque cristal et dans lequel lesdites portions d'engagement de pièce à usiner sont reçues dans lesdits puits pendant les étapes a) et b).

16. Procédé selon la revendication 14, **caractérisé de plus en ce que** la portion d'engagement de la pièce à usiner de chaque cristal est une face cubique du cristal, dans lequel les puits de récepteur sont configurés pour y recevoir les portions d'engagement de la pièce à usiner et présentent ainsi des parois de fond et des parois latérales verticales, et dans lequel lesdites portions d'engagement de la pièce à usiner des cristaux s'adaptent dans les puits de récepteur contre les parois de fond de ceux-ci pendant les étapes a) et b).

17. Procédé selon la revendication 14, **caractérisé de plus en ce que** la portion d'engagement de la pièce à usiner de chaque cristal est une arête de coupe en forme de V et les puits de récepteur sont complémentaires aux dites arêtes de coupe, et dans lequel les arêtes de coupe en forme de V s'adaptent dans les puits de récepteur pendant les étapes a) et b).

18. Procédé selon la revendication 14, **caractérisé de plus en ce que** lesdits cristaux abrasifs sont sélectionnés dans le groupe consistant en diamant et nitrure de bore cubique (CBN).
